# EUROPEAN PATENT SPECIFICATION

(11) **EP 1 814 163 B1**
(45) Date of publication and mention of the grant of the patent: **30.12.2009**
(21) Application number: 06253772.5
(22) Date of filing: 19.07.2006
(51) Int. Cl.: H01L 33/00

(54) **Light emitting diode packaging structure**
Gehäusestruktur für Licht-emittierende Diode
Structure de boîtier pour diode électroluminescente

(30) Priority: 25.01.2006 CN 200610001763
(43) Date of publication of application: 01.08.2007
(73) Proprietor: Everlight Electronics Co., Ltd., Tu Chen City, Taipei Hsien (TW)
(72) Inventor: Yeh, Robert, Miaoli County 358 (TW); Chuang, Shih-Jen, Taoyuan Hsien (TW)
(74) Representative: Calderbank, Thomas Roger

(56) References cited:
- WO-A-01/24281
- DE-A1- 10 147 986
- JP-A- 6 204 569
- JP-A- 61 148 883
- US-A- 3 914 786
- US-A1- 2003 107 316
- US-A1- 2004 248 332
- US-A1- 2005 116 238

## Description

The invention relates to a packaging structure and the manufacturing method thereof. In particular, the invention relates to an LED packaging structure and the manufacturing method thereof.

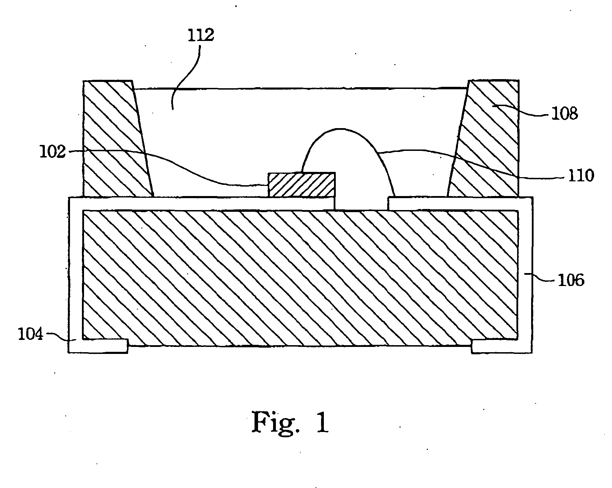

Light emitting diodes (LED) have the features of long lifetime, low power consumption, safety, and fast reactions. With technical progress, the brightness of the LED becomes higher, enlarging its applications. The conventional LED is fabricated using a metal lead frame along with plastic injection molding. FIG. 1 shows a cross-sectional view of the conventional LED structure with a lead frame.

Two lead frames 104, 106 are connected to the positive and negative electrodes of the LED chip 102, respectively. In the prior art, the injection molding method is employed to wrap the packaging materials and to fix the lead frames, forming a body 108. The body 108 is used as an auxiliary object for the LED chip 102 in the subsequent packaging. A concave region is formed in the body 108 for accommodating the LED chip 102. The positive pole of the LED chip 102 is directly connected to a first lead frame 104 and its negative pole via a wire 110 to a second lead frame 106. A packaging glue 112 is a transparent material that fills the concave region during the packaging step, covering the LED chip 102.

In this conventional structure, the chip accommodating space is defined by the packaging body formed by injection. Only a light opening is left for the light from the chip to be emitted. The commonly used packaging body is made of an opaque and thermal resistant material, such as polyphthalamide (PPA). When the chip emits light, some indirectly emitted light hits the inside of the accommodating space. The incident light is absorbed, reflected, and scattered by the sidewall. Only very little indirectly emitted light leaves the light opening. Most of the light is wasted by the packaging material absorption during the multiple reflections and scatterings.

Therefore, the output efficiency of the LED device is reduced by the optical absorption, resulting in considerable energy waste.

One objective of the invention is to provide an LED packaging structure and the manufacturing method thereof for increasing the light output efficiency and reducing energy loss.

Another objective of the invention is to provide an LED packaging structure and the manufacturing method thereof for obtaining a desired light output angle.

A further objective of the invention is to provide an LED packaging structure and the manufacturing method thereof for increasing the heat dissipation of the light-emitting device.

A light emitting diode packaging structure according to the invention is defined by claim 1.

In accord with the above objectives, the disclosed LED packaging structure includes a packaging body, a lead frame and a reflective wall. The package body includes a chip accommodating space for an LED chip, and a portion of the lead frame is exposed to the chip accommodating space. The reflective wall is connected with the lead frame and extendedly bends from the lead frame to cover a sidewall of the accommodating space so that rays of the LED chip can reflect from the reflective wall mostly.

A manufacturing method of a LED packaging structure according to the invention is defined by claim 7.

The manufacturing method of the LED packaging structure includes the steps of: forming a first lead frame and a reflective wall connected to the first lead frame from a plate material; and using the packaging body to cover a portion of the first lead frame, a portion of a second lead frame, and the reflective wall by injection molding.

Another manufacturing method of a LED packaging structure according to the invention is defined by claim 11.

According to a preferred embodiment of the invention, the manufacturing method of the LED packaging structure further includes the steps of using a plate material to form a first lead frame and a reflective wall connected to the first lead frame, coating a highly reflective material on the reflective wall; using a packaging body to cover a portion of the first lead frame, a portion of a second lead frame, and the reflective wall using injection molding; employing a chip fixing step to fix the chip on any of the lead frames, using a bonding step to connect the LED chip with the other lead frame without an LED chip; and employing a gluing step to fill the chip accommodating space of the packaging body.

The step of forming the first lead frame and the reflective wall include the steps of: reserving on the plate material the reflective wall connected to the first lead frame; and bending an interface between the reflective wall and the lead frame. Alternatively, one may form a cup-shaped recession in one portion of the plate material by stamping. The two adjacent surfaces of the recession are used as the lead frame and the reflective wall, respectively.

In summary, the disclosed LED packaging structure provides a design that reduces optical energy loss and has high optical output efficiency. It further has the advantages of helping heat dissipation and controlling the light output angle. The manufacturing method does not require any additional special equipment. The reflective wall is formed concurrently in the same step as forming the lead frame. No additional material is needed.

Patent Applications US 2004/0248332 and DE 10147986 disclose LED packages comprising a bended lead frame comprised of a reflector.

These and other features, aspects and advantages of the invention will become apparent by reference to the following description and accompanying drawings which are given by way of illustration only, and thus are not limitative of the invention, and wherein:
FIG. 1 shows a cross-sectional view of the conventional LED structure with a lead frame;
FIG. 2A is a three-dimensional view of the LED packaging structure in a preferred embodiment of the invention;
FIG. 2B is a schematic view of the initial lead frame plate material in the preferred embodiment;
FIG. 3 is a flowchart illustrating the manufacturing method of the disclosed LED packaging structure; and
FIG. 4 is a schematic view of the initial lead frame plate material in another embodiment of the invention.

The present invention will be apparent from the following detailed description, which proceeds with reference to the accompanying drawings, wherein the same references relate to the same elements.

The disclosed packaging structure uses the body of the lead frame to directly form external lead pins and the reflective wall inside the chip accommodating space. The manufacturing process is simple and convenient. No additional special equipment is required. The packaging structure thus made has the advantages of reducing energy loss and increasing light output efficiency.

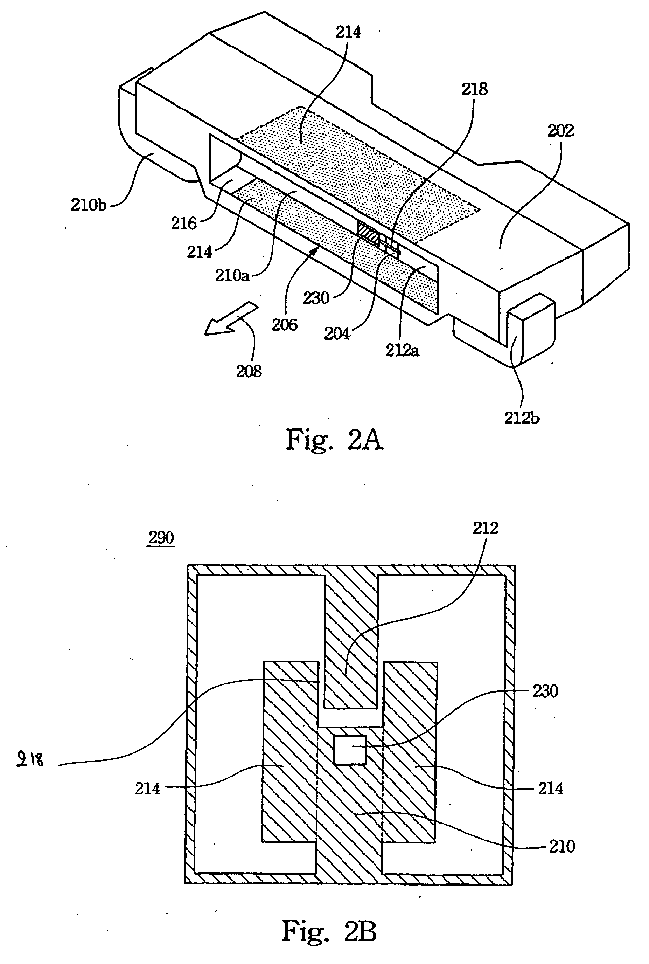

With reference to FIG. 2A, the LED packaging structure includes a packaging body 202 with a chip accommodating space 204 defined by a recession structure inside the packaging body 202 for accommodating an LED chip; a lead frame 212 whose one portion is embedded in the packaging body 202 and exposed in the chip accommodating space 204, and a reflective wall 214 connected to the lead frame 210 and extendedly bending from the lead frame 210 to cover a sidewall 216 of the accommodating space 204.

In a preferred embodiment, the LED packaging structure include the packaging body 202, a first lead frame 210 (depicted in FIG. 2B) and a second lead frame 212 (depicted in FIG. 2B). The lead frames are embedded in the packaging body 202 by one portion, the embedded portions 210a and 212a. The rest portions are exposed, the exposed portions 210b and 212b. The embedded portions refer to the portions that are covered by the material of the packaging body 202 and the portions exposed in the chip accommodating space 204.

The material of the packaging body can be ordinary PPA, epoxy, glass fiber, titanium oxide, calcium oxide, or their combinations.

The LED chip 230 is directly disposed on the embedded portion 210a of the first lead frame. It is connected to the embedded portion 212a of the second lead frame via a wire 218 by bonding. The combination of the first lead frame 210 and the second lead frame 212 represents the combination of the positive and negative lead pins in the device for guiding an external current to illuminate the LED device.

The drawing shows a side-view LED packaging structure. The light output direction 208 of the LED chip faces the light opening 206 of the packaging body 202. The sidewall 216 of the packaging body 202 expands gradually toward the light opening 206. This inclination design ensures that the light will emit via the light opening 206 after multiple internal reflections. It has the function of controlling the light output angle.

When the LED chip 230 emits light via the light opening 206, a portion of indirectly emitted light travels toward the sidewall 216 of the packaging body 202. Since the sidewall 216 is already covered with a reflective wall 214, most of the optical energy is stored. Even after many reflections, the energy loss is still far less than the energy waste in the conventional packaging body 202.

Since the reflective wall is connected to the lead frame, it helps dissipating the heat from the LED chip. Due to the metal with a high reflectivity, the light incident direction can be more easily and accurately predicted as the device emits light. By simulation or calculation, one can design an LED device with high reappearance, high reliability, and a specific light output angle.

FIG. 2B is a schematic view of the initial lead frame plate Material. The manufacturing method of the disclosed reflective wall is the follows. A region by the first lead frame 210 of the initial lead frame plate material is reserved 290 for the reflective wall 214. Afterwards, the plate material in the reserved region is bended according to the bending line in the drawing to form a reflective surface. The two lead frames 210 and 212 in this embodiment are made using the same plate material 290. Two opposite reflective walls 214 are reserved. The lead frame is usually made of a metal material, such as Au, Ag, Cu, Fe, Al, or their alloy.

Although the above-mentioned reflective walls are made of the same material as the lead frames, the region of the reflective walls is preferably coated with a material with a high reflectivity. For example, silver can be coated on the lead frame made of an iron or copper alloy to achieve a higher reflectivity. This can reduce a lot of energy loss.

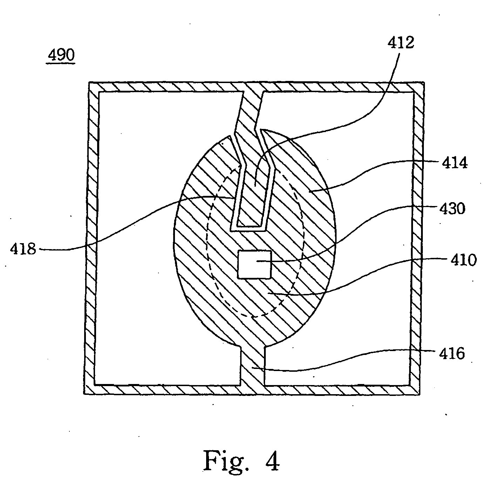

As shown in FIG. 4, the lead frame material is bended to form the reflective walls by stamping in another embodiment of the invention, stamping a cup-shaped recession in the lead frame plate material 490. The first lead frame 410 is disposed with an LED chip 430 and connected to the reflective wall 414. The interface is indicated by a bending line. The interface between the reflective wall 414 and the first lead frame 410 is also a bending structure. A tail portion 416 is connected to the reflective wall 414. The tail portion 416 is formed by injection molding, with one portion embedded inside the packaging body and one portion exposed as the external lead pin, as the exposed portion 210b in FIG. 2A. Likewise, the second lead frame 412 in this embodiment is concurrently made using the same plate material too.

In addition, the first lead frame 410 and the reflective wall 414 further include an opening 418 extending from the reflective wall 414 to the first lead frame. 410. The second lead frame 412 is inserted into the opening 418 so that the second lead frame 412 is close to the LED chip 430. Therefore, the length of the bonding wire for connecting the second lead frame 412 and the LED chip 430 can be effectively reduced.

There is one advantage for the lead frame structure obtained using the stamping method. The reflective walls formed by stamping almost surround the chip. Therefore, the reflective region provided by the inside of the packaging body is wider. The effects must be greatly enhanced. In the above two embodiments, the connection portion of the two lead frames in the plate material can be cut off after the packaging body is formed by injection molding and the two lead frames are covered, thereby forming independent electrode lead pins.

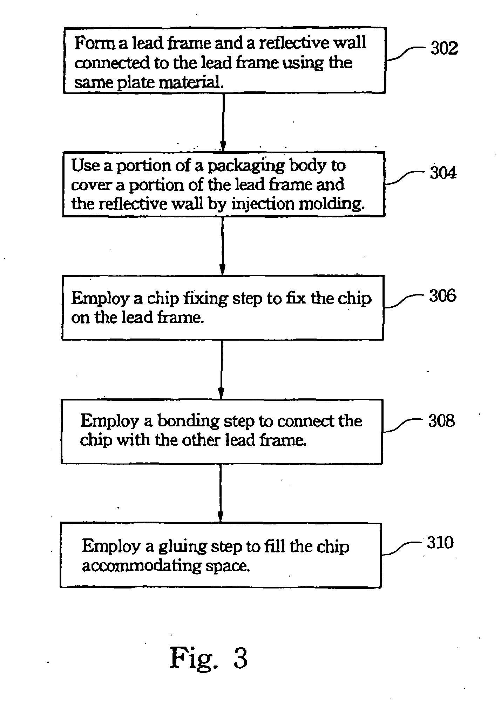

With reference to FIG. 3, the disclosed manufacturing method of the LED packaging structure according to a preferred embodiment of the invention includes the following steps. A lead frame and a reflective wall connected to the lead frame are formed using the same plate material (step 302). A portion of a packaging body covers a portion of the lead frame and the reflective wall by injection molding (step 304). A chip fixing step is employed to fix the chip on the lead frame (step 306). A bonding step is employed to connect the chip with another lead frame (step 308). A gluing step is employed to fill the chip accommodating space (step 310). Before the injection molding, the reflective wall can be coated with a highly reflective material such as silver.

The step of forming the lead frame and the reflective wall is detailed as follows. The plate material is reserved with a reflective wall connected to any of the lead frames. The interface between the reflective wall and the lead frame is bended to form the reflective wall, as illustrated in FIG. 2B.

One may first form a cup-shaped recession in a portion of the plate material by stamping. Two adjacent surfaces of the cup-shaped recession are the first lead frame and the reflective wall, as shown in FIG. 4. It should be noted that the recession structure thus formed does not limit the correspondence relation between any surface and any device. For example, the top-view and side-view devices can have different definitions.

In accord with the preferred embodiments, the invention has at least the following advantages. The reflective wall is defined in the same step as the lead frame, so that the final packaging structure reduces its energy loss and increases the light output efficiency with the help of the reflective wall. The reflective wall also helps dissipating heat from the device. Besides, the high reflectivity of the reflective wall renders the light output control of the LED device easier, unlike the conventional packaging body that has uncertainty in light output angle.

The method of concurrently forming the reflective wall and the lead frame does not require additional special equipment. Therefore, its production is simple, and the material cost is low.

The invention being thus described, it will be obvious that the same may be varied in many ways. Such variations are not to be regarded as a departure from the scope of the invention, and all such modifications as would be obvious to one skilled in the art are intended to be included within the scope of the following claims, as interpreted by the description and drawings.

## Claims

1. A light emitting diode (LED) packaging structure comprising:
a packaging body (202) having a chip accommodating space (204) for accommodating an LED chip (230);
a lead frame (210, 410), a portion of which is exposed to the chip accommodating space;
a reflective wall (214, 414) connected to the lead frame and extendedly bending from the lead frame to cover a sidewall of the accommodating space so that rays of the LED chip are mostly reflected from the reflective wall; and **characterized in that** it comprises an opening (218, 418) extending from the reflective wall to the lead frame; and another lead frame (212,412) inserted into the opening.

2. The LED packaging structure of claim 1, wherein the material of the packaging body is selected from the group consisting of epoxy, glass fiber, titanium oxide, calcium oxide, and their combinations.

3. The LED packaging structure of claim 1, wherein the lead frame and the reflective wall form a cup-shaped Structure.

4. The LED packaging structure of claim 1, wherein the material of the lead from is selected from the group consisting of gold, solver, copper, iron, aluminum and their alloys.

5. The LED packaging structure of claim 1. wherein the material of the reflective wall is the same as the lead frame.

6. The LED packaging structure of claim 1, wherein the material of the reflective wall is silver.

7. A manufacturing method of an LED packaging structure, comprising the steps of:
using a plate material to form a first lead frame (210, 410) and a reflective wall (214, 414) connected to
the lead frame, wherein the first lead frame and the reflective wall further comprises an opening (218,418), and
using a packaging body to cover a portion of the first lead frame, a portion of a second lead frame, and the reflective wall by injection molding, wherein the second lead frame (212,412) is inserted into the opening.

8. The manufacturing method of claim 7, wherein the step of injection molding is preceded by the step of coating a highly reflective maternal on the reflective wall.

9. The manufacturing method of claim 7, wherein the step of forming a first lead frame and a reflective wall includes the steps of reserving the reflective wall connected to the first lead frame on the plate material; and bending an interface between the reflective wall and the lead frame.

10. the manufacturing method of claim 7, wherein the step of forming a first lead frame and a reflective wall includes the step of forming a cup-shaped recession in one portion of the plate material by stamping.

11. A manufacturing method of an LED packaging structure, comprising the steps of:
using a plate material to form a first lead frame and a reflective wall (214,414) connected to the lead frame;
using a packaging body to cover a portion of the first lead frame (210, 410), a portion of a second lead frame (212,412) and the reflective wall by injection molding;
implementing a chip fixing step to fix an LED chip (230) on any of the lead frames, wherein the any of the lead frames further comprises an opening (218,418),
implementing a bonding step to electrically connect the LED chip and the other lead frame without the LED chip, wherein the other lead frame without the LED chip is inserted into the opening; and
implementing a gluing step to fill a chip accommodating space of the packaging body.

12. The manufacturing method of claim 11, wherein the step of injection molding is preceded by the step of coating a highly reflective material on the reflective wall.

13. The manufacturing method of claim 11, wherein the step of forming a first lead frame and a reflective wall includes the steps of: reserving the reflective wall connected to the first lead frame on the plate material; and bending an interface between the reflective wall and the lead flame.

14. The manufacturing method of claim 11, wherein the step of forming a first lead frame and a reflective wall includes the step of forming a cup-shaped recession in one portion of the plate material by stamping.

## Patentansprüche

1. Gehäusestruktur für eine lichtemittierende Diode (LED), umfassend:
einen Gehäusekörper (202) mit einem Raum (204) zur Aufnahme eines Chips zur Aufnahme eines LED-Chips (230);
einen Anschlussrahmen (210, 410), von dem ein Teil gegenüber dem Raum zur Aufnahme des Chips freiliegt;
eine reflektierende Wand (214, 414), die mit dem Anschlussrahmen verbunden ist und sich gekrümmt von dem Anschlussrahmen weg erstreckt, um eine Seitenwand des Raums zur Aufnahme des Chips zu bedecken, sodass von dem LED-Chip ausgehende Strahlen großteils von der reflektierenden Wand reflektiert werden;
**dadurch gekennzeichnet, dass** sie eine Öffnung (218, 418), die sich von der reflektierenden Wand zu dem Anschlussrahmen erstreckt, und einen weiteren Anschlussrahmen (212, 412) umfasst, der in die Öffnung eingesetzt wird.

2. LED-Gehäusestruktur nach Anspruch 1, worin das Material für den Gehäusekörper aus der aus Epoxy, Glasfaser, Titanoxid, Calciumoxid und Kombinationen davon bestehenden Gruppe ausgewählt ist.

3. LED-Gehäusestruktur nach Anspruch 1, worin der Anschlussrahmen und die reflektierende Wand eine schalenförmige Struktur bilden.

4. LED-Gehäusestruktur nach Anspruch 1, worin das Material für den Anschlussrahmen aus der aus Gold, Silber, Kupfer, Eisen, Aluminium und deren Legierungen bestehenden Gruppe ausgewählt ist.

5. LED-Gehäusestruktur nach Anspruch 1, worin das Material der reflektierenden Wand dem Material des Anschlussrahmens entspricht.

6. LED-Gehäusestruktur nach Anspruch 1, worin das Material der reflektierenden Wand Silber ist.

7. Herstellungsverfahren für eine LED-Gehäusestruktur, umfassend folgende Schritte:
Verwendung eines Plattenmaterials zur Ausbildung eines ersten Anschlussrahmens (210, 410) und einer reflektierenden Wand (214, 414), die mit dem Anschlussrahmen verbunden ist, wobei der erste Anschlussrahmen und die reflektierende Wand ferner eine Öffnung (218, 418) umfassen und
Verwendung eines Gehäusekörpers zum Abdecken eines Teils des ersten Anschlussrahmens, eines Teils des zweiten Anschlussrahmens und der reflektierenden Wand durch Spritzgießen, wobei der zweite Anschlussrahmen (212, 412) in die Öffnung eingesetzt wird.

8. Herstellungsverfahren nach Anspruch 7, worin dem Schritt des Spritzgießens ein Schritt des Beschichtens eines hochreflektierenden Materials auf die reflektierende Wand vorausgeht.

9. Herstellungsverfahren nach Anspruch 7, worin der Schritt des Ausbildens eines ersten Anschlussrahmens und einer reflektierenden Wand folgende Schritte umfasst: Aussparen der mit dem ersten Anschlussrahmen verbundenen reflektierenden Wand auf dem Plattenmaterial und Biegen eines Übergangsbereichs zwischen der reflektierenden Wand und dem Anschlussrahmen.

10. Herstellungsverfahren nach Anspruch 7, worin der Schritt des Ausbildens eines ersten Anschlussrahmens und einer reflektierenden Wand den Schritt des Ausbildens einer schalenförmigen Ausnehmung in einem Abschnitt des Plattenmaterials durch Stanzen umfasst.

11. Herstellungsverfahren für eine LED-Gehäusestruktur, umfassend folgende Schritte:
Verwendung eines Plattenmaterials zur Ausbildung eines ersten Anschlussrahmens und einer mit dem Anschlussrahmen verbundenen reflektierenden Wand (214, 414);
Verwendung eines Gehäusekörpers zum Abdecken eines Teils des ersten Anschlussrahmens (210, 410), eines Teils eines zweiten Anschlussrahmens (212, 412) und der reflektierenden Wand durch Spritzgießen;
Ausführen eines Schritts zur Befestigung eines Chips, um einen LED-Chip (230) an einem der Anschlussrahmen zu befestigen, wobei der Anschlussrahmen ferner eine Öffnung (218, 418) umfasst;
Ausführen eines Verbindungsschritts, um den LED-Chip und den anderen Anschlussrahmen ohne LED-Chip elektrisch zu verbinden, wobei der andere Anschlussrahmen ohne LED-Chip in die Öffnung eingesetzt wird; und
Ausführen eines Klebeschritts, um einen Raum des Gehäusekörpers zur Aufnahme eines Chips zu füllen.

12. Herstellungsverfahren nach Anspruch 11, worin dem Schritt des Spritzgießens ein Schritt des Beschichtens eines hochreflektierenden Materials auf die reflektierende Wand vorausgeht.

13. Herstellungsverfahren nach Anspruch 11, worin der Schritt des Ausbildens eines ersten Anschlussrahmens und einer reflektierenden Wand folgende Schritte umfasst: Aussparen der mit dem ersten Anschlussrahmen verbundenen reflektierenden Wand auf dem Plattenmaterial und Biegen eines Übergangsbereichs zwischen der reflektierenden Wand und dem Anschlussrahmen.

14. Herstellungsverfahren nach Anspruch 11, worin der Schritt des Ausbildens eines ersten Anschlussrahmens und einer reflektierenden Wand den Schritt des Ausbildens einer schalenförmigen Ausnehmung in einem Abschnitt des Plattenmaterials durch Stanzen umfasst.

## Revendications

1. Structure de boîtier pour diode électroluminescente (DEL) comprenant:
un corps de boîtier (202) comportant un espace de réception de puce (204) pour loger une puce DEL (230);
une grille de connection (210, 410) dont une portion est exposée à l'espace de logement de puce;
une paroi de réflexion (214, 414) reliée à la grille de connection et s'étendant d'une manière courbée de la grille de connection pour couvrir une paroi latérale de l'espace de réception de sorte que des rayons de la puce DEL sont sensiblement réfléchis de la paroi de réflexion; et **caractérisée en ce qu'**elle comprend une ouverture (218, 418) s'étendant de la paroi de réflexion à la grille de connection; et
une autre grille de connection (212, 412) insérée dans l'ouverture.

2. Structure de boîtier pour DEL selon la revendication 1, dans laquelle le matériau du corps de boîtier est sélectionné dans le groupe consistant en époxy, fibres de verre, oxyde de titane, oxyde de calcium et leurs combinaisons.

3. Structure de boîtier pour DEL selon la revendication 1, dans laquelle la grille de connection et la paroi de réflexion forment une structure en forme de coupelle.

4. Structure de boîtier pour DEL selon la revendication 1, dans laquelle le matériau de la grille de connection est sélectionné dans le groupe consistant en or, argent, cuivre, fer, aluminium et leurs alliages.

5. Structure de boîtier pour DEL selon la revendication 1, dans laquelle le matériau de la paroi de réflexion est le même que celui de la grille de connection.

6. Structure de boîtier pour DEL selon la revendication 1, dans laquelle le matériau de la paroi de réflexion est l'argent.

7. Procédé de fabrication d'une structure de boîtier pour DEL, comprenant les étapes de:
utiliser un matériau de plaque pour former une première grille de connection (210, 410) et une paroi de réflexion (214, 414) reliée à la grille de connection, où la première grille de connection et la paroi de réflexion comprennent en outre une ouverture (218, 418); et
utiliser un corps de boîtier pour couvrir une portion de la première grille de connection, une portion d'une deuxième grille de connection et la paroi de réflexion par moulage par injection, où la deuxième grille de connection (212, 412) est insérée dans l'ouverture.

8. Procédé de fabrication selon la revendication 7, dans lequel l'étape du moulage par injection est précédée de l'étape consistant à appliquer un matériau hautement réfléchissant sur la paroi de réflexion.

9. Procédé de fabrication selon la revendication 7, dans lequel l'étape consistant à former une première grille de connection et une paroi de réflexion comprend les étapes de: réserver la paroi de réflexion reliée à la première grille de connection sur le matériau de plaque; et courber une interface entre la paroi de réflexion et la grille de connection.

10. Procédé de fabrication selon la revendication 7, dans lequel l'étape consistant à former une première grille de connection et une paroi de réflexion comprend l'étape consistant à former un évidement en forme de coupelle dans une portion du matériau de plaque par estampage.

11. Procédé de fabrication d'une structure de boîtier pour DEL, comprenant les étapes de:
utiliser un matériau de plaque pour former une première grille de connection et une paroi de réflexion (214, 414) reliée à la grille de connection;
utiliser un corps de boîtier pour couvrir une portion de la première grille de connection (210; 410), une portion d'une deuxième grille de connection (212, 412) et la paroi de réflexion par moulage par injection;
mettre en oeuvre une étape de fixation de puce pour fixer une puce DEL (230) sur une quelconque des grilles de connection, où l'une quelconque des grilles de connection comprend en outre une ouverture (218, 418);
mettre en oeuvre une étape de liaison pour connecter électriquement la puce DEL et l'autre grille de connection sans puce DEL, où l'autre grille de connection sans puce DEL est insérée dans l'ouverture; et
mettre en oeuvre une étape de collage pour remplir un espace de réception de puce du corps de boîtier.

12. Procédé de fabrication selon la revendication 11, dans lequel l'étape du moulage par injection est précédée de l'étape consistant à appliquer un matériau hautement réfléchissant à la paroi de réflexion.

13. Procédé de fabrication selon la revendication 11, dans lequel l'étape consistant à former une première grille de connection et une paroi de réflexion comprend les étapes de: réserver la paroi de réflexion connectée à la première grille de connection sur le matériau de plaque; et courber une interface entre la paroi de réflexion et la grille de connection.

14. Procédé de fabrication selon la revendication 11, dans lequel l'étape consistant à former une première grille de connection et une paroi de réflexion comprend l'étape consistant à former un évidement en forme de coupelle dans une portion du matériau de plaque par estampage.
